# EUROPEAN PATENT APPLICATION

(11) **EP 4 679 010 A1**
(43) Date of publication of application: **14.01.2026**
(21) Application number: 23927322.0
(22) Date of filing: 10.03.2023
(51) Int. Cl.: F25B 49/02

(54) **ELECTRICAL COMPONENT BOX**

(71) Applicant: Daikin Industries, Ltd., Osaka-shi, Osaka 530-0001 (JP); Daikin Europe N.V., 8400 Oostende (BE)
(72) Inventor: TAMBA, Takashi, Osaka-shi, Osaka 530-0001 (JP); OKA, Yasuhiko, Osaka-shi, Osaka 530-0001 (JP); HISAYAMA, Kazushi, Osaka-shi, Osaka 530-0001 (JP); AKUTAGAWA, Kazuki, Osaka-shi, Osaka 530-0001 (JP); DELOMBAERDE, Jonathan, 8400 Oostende (BE); VERMEERSCH, Maxim, 8400 Oostende (BE)
(74) Representative: Hoffmann Eitle
(86) International application number: PCT/JP2023/009414
(87) International publication number: WO 2024/189698

(57) **Abstract**

An electric component box that achieves both safety and cooling inside the electric component box is provided. An electric component box 70 that is mounted in a heat pump unit 100 and includes electric components inside includes an inner box 50 and an outer box 60. The inner box 50 accommodates a printed circuit board 43 on which the electric components are mounted, and has a sealed structure. The outer box 60 covers the inner box 50. In the electric component box 70, since the inflow of gas into the inner box 50 is suppressed, for example, the contact of air containing a pollutant or flammable gas with electrodes of the electric components is also suppressed.

## Description

### TECHNICAL FIELD

The present disclosure relates to an electric component box mounted in a heat source unit of a refrigeration apparatus.

### BACKGROUND ART

As a structure of an electric component box that accommodates electric components, for example, Patent Literature 1 (JP-A-2008-196767) discloses a double-structured electric component box including an inner box and an outer box. This electric component box is provided with an opening that allows air to flow into the inner box to cool the interior of the inner box.

### SUMMARY OF THE INVENTION

### <Technical Problem>

However, in the electric component box as described above, air flowing into the outer box flows into the inner box through the opening. Therefore, if air containing a flammable gas flows in, there is a risk of ignition. Therefore, an electric component box that achieves both safety and cooling of the interior of the electric component box is desired.

### <Solution to Problem>

An electric component box of a first aspect is an electric component box that is mounted in a heat source unit of a refrigeration apparatus and includes an electric component inside, and includes an inner box and an outer box. The inner box accommodates a board on which the electric component is mounted and has a sealed structure. The outer box covers the inner box.

In this electric component box, since the inflow of gas into the inner box is suppressed, for example, the contact of air containing a pollutant or flammable gas with electrodes of the electric component is also suppressed.

The electric component box of a second aspect is an electric component box of the first aspect, in which an interior of the heat source unit is partitioned by a partition plate into a machine chamber and a fan chamber. A compressor is disposed in the machine chamber. A fan and a heat exchanger are disposed in the fan chamber. The electric component box is disposed in the fan chamber.

In this electric component box, for example, assuming that a refrigerant leaks in the heat source unit that uses a flammable refrigerant, it is possible to suppress contact between the flammable refrigerant and the electric component by disposing the electric component box in the fan chamber, in which the gas concentration is more likely to be lowered by rapid diffusion of the flammable refrigerant by the fan, rather than in the machine chamber, in which the flammable refrigerant is likely to accumulate.

The electric component box of a third aspect is an electric component box of the second aspect, in which the outer box includes an opening to introduce outside air.

In this electric component box, since the interior of the inner box, which has a sealed structure, is easy to rise in temperature, it is possible to cool the inner box from the outside by introducing outside air from the outer box.

The electric component box of a fourth aspect is an electric component box of the third aspect, in which the opening is provided on a front surface of the outer box when the outer box is viewed from a front of the fan chamber, the front surface being farthest from the machine chamber in the outer box.

In this electric component box, for example, in the heat source unit that uses a flammable refrigerant, assuming a case where the refrigerant leaks from the machine chamber, if the opening is away from the machine chamber, the flammable refrigerant is unlikely to be drawn in even if the flammable refrigerant leaks from the machine chamber. In the fan chamber, the air drawn in from the rear is blown out forward from a front blow-out port. Therefore, if the opening is located on the front surface, the air containing a flammable refrigerant is unlikely to be drawn in.

The electric component box of a fifth aspect is an electric component box of any one of the first aspect to the fourth aspect, in which a heat sink is attached to the inner box.

In this electric component box, since the interior of the inner box, which has a sealed structure, is easy to rise in temperature, it is possible to suppress the temperature rise inside the inner box by cooling the interior of the inner box with the heat sink.

The electric component box of a sixth aspect is an electric component box of the fifth aspect, in which the heat sink is configured to exchange heat between an interior of the inner box and an interior of the outer box.

In this electric component box, since the heat in the interior of the inner box moves to the interior of the outer box, the cooling of the interior of the inner box is promoted.

The electric component box of a seventh aspect is an electric component box of the fifth aspect, in which the heat sink is configured to exchange heat between an interior of the inner box and an exterior of the outer box.

In this electric component box, since the heat in the interior of the inner box moves to the exterior of the outer box, the cooling of the interior of the inner box is promoted.

The electric component box of an eighth aspect is an electric component box of the seventh aspect, in which an intelligent power module is mounted on the board. The heat sink is configured to exchange heat between the intelligent power module and the exterior of the outer box.

In this electric component box, since the heat of the intelligent power module, which is a heat source, moves to the exterior of the outer box, the cooling of the intelligent power module is promoted.

The electric component box of a ninth aspect is an electric component box of any one of the third aspect to the eighth aspect, further including a fan that generates air flow.

In this electric component box, since air is circulated by forced convection inside, the cooling inside the electric component box is promoted.

The electric component box of a tenth aspect is an electric component box of the ninth aspect, in which the fan is disposed inside the inner box.

In this electric component box, since air is circulated by forced convection inside the inner box, the cooling of the interior of the inner box is promoted.

The electric component box of an eleventh aspect is an electric component box of the ninth aspect, in which the fan is disposed in the opening or a space sandwiched between the inner box and the outer box.

In this electric component box, since air is circulated by forced convection in the space sandwiched between the inner box and the outer box, the cooling inside the outer box is promoted.

The electric component box of a twelfth aspect is an electric component box of any one of the first aspect to the eleventh aspect, in which the inner box is constructed using aluminum or an aluminum alloy.

In this electric component box, since the interior of the inner box, which has a sealed structure, is easy to rise in temperature, by constructing the inner box using aluminum or an aluminum alloy, the heat dissipation of the inner box is enhanced and the temperature rise inside the inner box is suppressed.

The electric component box of a thirteenth aspect is an electric component box of any one of the first aspect to the twelfth aspect, in which the outer box is constructed using resin.

In this electric component box, the outer box is exposed to air whose temperature has increased through heat exchange with the heat exchanger. Therefore, by forming the outer box from resin having lower thermal conductivity than metal, the thermal insulation properties of the outer box are enhanced, and the temperature rise inside the outer box is suppressed.

The electric component box of a fourteenth aspect is an electric component box of any one of the first aspect to the thirteenth aspect, further including a heat pipe that cools the interior of the inner box.

In this electric component box, since the cooling performance is higher than air cooling, the temperature rise suppression effect inside the inner box is high.

The electric component box of a fifteenth aspect is an electric component box of any one of the first aspect to the fourteenth aspect, in which a refrigerant of the refrigeration apparatus includes a flammable refrigerant.

In this electric component box, even in the unlikely event that a flammable refrigerant leaks, since the inflow of the flammable refrigerant into the inner box having a sealed structure is suppressed, the risk of ignition due to contact with the electric component is extremely low.

The electric component box of a sixteenth aspect is an electric component box of any one of the first aspect to the fifteenth aspect, in which the inner box includes a box body and a lid part. The box body forms an accommodation space for the board. The lid part overlaps with the box body and closes the accommodation space. The overlapping part between the box body and the lid part includes a first flange, a second flange, and a sealing member. The first flange is provided on the box body. The second flange is provided on the lid part to overlap with the first flange. The sealing member seals between the first flange and the second flange.

The electric component box enhances the airtightness of the inner box by having the sealing member interposed between the flanges of the box body and the lid part.

The electric component box of a seventeenth aspect is an electric component box of the sixteenth aspect, in which the overlapping part further includes a fastening member. The fastening member fastens the first flange and the second flange in a direction to compress the sealing member.

In this electric component box, since the sealing member sandwiched between the flanges of the box body and the lid part is compressed and adheres closely to respective flanges, the airtightness of the inner box is further enhanced.

The electric component box of the eighteenth aspect is an electric component box of the sixteenth aspect or the seventeenth aspect, in which the inner box further includes a through hole and a cable gland. The through hole is a hole through which a wire passes. The cable gland is inserted into the through hole together with the wire, and seals between the through hole and the wire.

In this electric component box, the gap between the through hole and the wire is sealed, thereby further enhancing the airtightness of the inner box.

A heat source unit according to a nineteenth aspect includes the electric component box according to any one of the first aspect to the eighteenth aspect.

### BRIEF DESCRIPTION OF THE DRAWINGS

FIG. 1 is an external perspective view of a heat pump unit, which is a refrigeration apparatus in which an electric component box according to a first embodiment of the present disclosure is mounted.
FIG. 2 is a perspective view inside the heat pump unit of FIG. 1.
FIG. 3 is a cross-sectional view of the electric component box according to the first embodiment of the present disclosure.
FIG. 4 is an enlarged cross-sectional view of an inner box.
FIG. 5 is a cross-sectional view of an electric component box according to a second embodiment.
FIG. 6 is a cross-sectional view of an electric component box according to a third embodiment.

### DESCRIPTION OF EMBODIMENTS

### <First embodiment>

### (1) Configuration of refrigeration apparatus

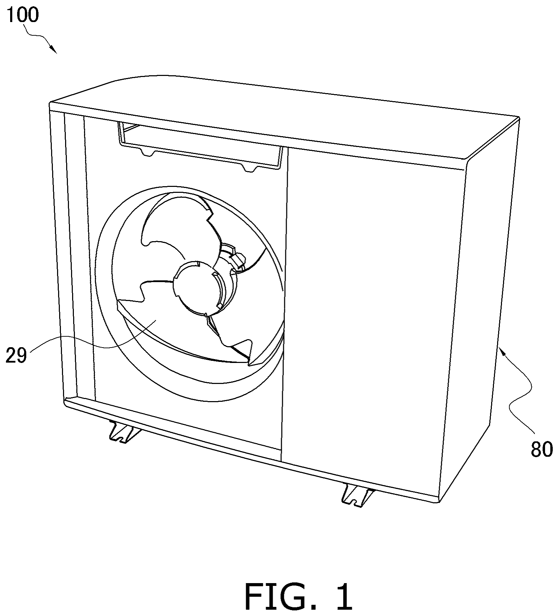

FIG. 1 is an external perspective view of a heat pump unit 100, which is a refrigeration apparatus in which an electric component box 70 according to a first embodiment of the present disclosure is mounted. In FIG. 1, a part of the front surface of a casing 80 is intentionally cut away to make a fan 29 visible.

In FIG. 1, the heat pump unit 100 is utilized in a household hot water supply system. However, the heat pump unit 100 can be applied to many other applications.

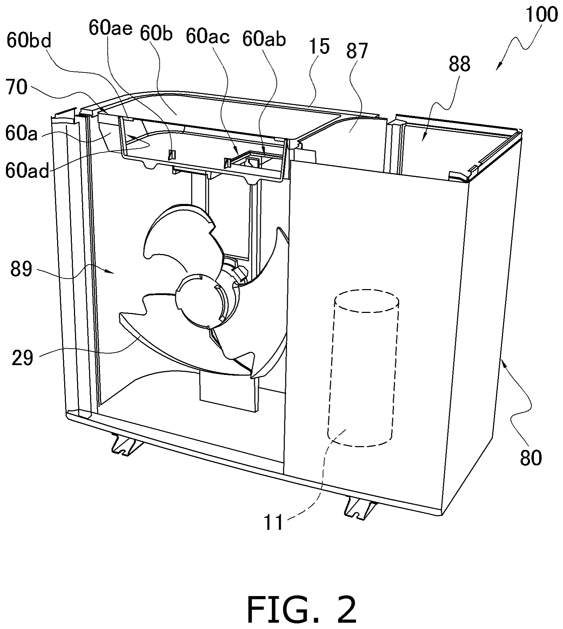

FIG. 2 is a perspective view inside the heat pump unit 100 of FIG. 1. In FIG. 2, most of components of the heat pump unit 100 are accommodated in the casing 80.

The interior of the casing 80 is partitioned by a partition plate 87 into a machine chamber 88 on the right side and a fan chamber 89 on the left side in the front view of FIG. 2.

A compressor 11 is accommodated in the machine chamber 88. A first heat exchanger 15 and the fan 29 that blows air to the first heat exchanger 15 are accommodated in the fan chamber 89.

The heat pump unit 100 includes a refrigerant circuit in which the compressor 11, the first heat exchanger 15, a decompression valve (not shown), and a second heat exchanger (not shown) are connected in a loop. The heat pump unit 100 circulates a refrigerant in the refrigerant circuit to transfer thermal energy between the first heat exchanger 15 and the second heat exchanger. The refrigerant is preferably a hydrocarbon such as R290, which has both low ozone depletion potential and low global warming potential.

In the heat pump unit 100, the electric component box 70 is disposed above the fan 29 in the fan chamber 89. FIG. 2 does not depict the contents of the electric component box 70, but in reality, the electric component box 70 accommodates a printed circuit board on which electric components such as a microprocessor, memory, and intelligent power module are mounted. The microprocessor controls the operating frequency of the compressor 11, monitors the discharge temperature of the compressor 11, controls the opening degree of the decompression valve, and performs other operations.

### (2) Configuration of electric component box 70

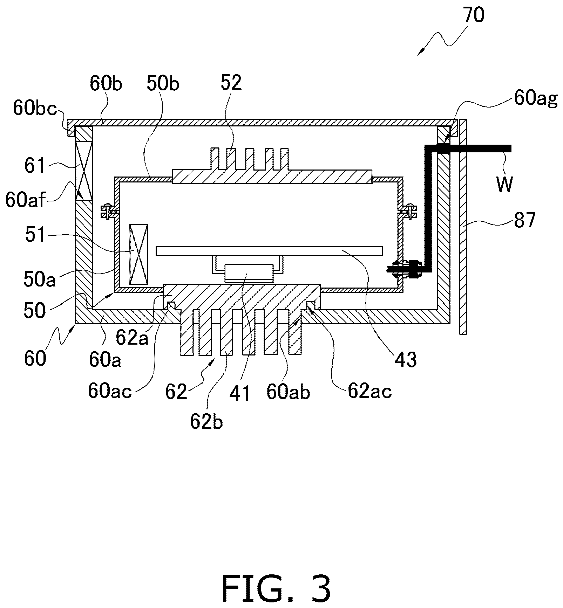

FIG. 3 is a cross-sectional view of the electric component box 70 according to the first embodiment of the present disclosure. In FIG. 3, the electric component box 70 has a double structure that covers an inner box 50 with an outer box 60.

The electric component box 70 is disposed in the fan chamber 89. Assuming that a flammable refrigerant leaks in the heat pump unit 100, it is possible to suppress contact between the flammable refrigerant and the electric components in the electric component box 70 by disposing the electric component box 70 in the fan chamber 89, in which the gas concentration is more likely to be lowered by rapid diffusion of the refrigerant by the fan 29, rather than in the machine chamber 88, in which the refrigerant is likely to accumulate.

### (2-1) Inner box 50

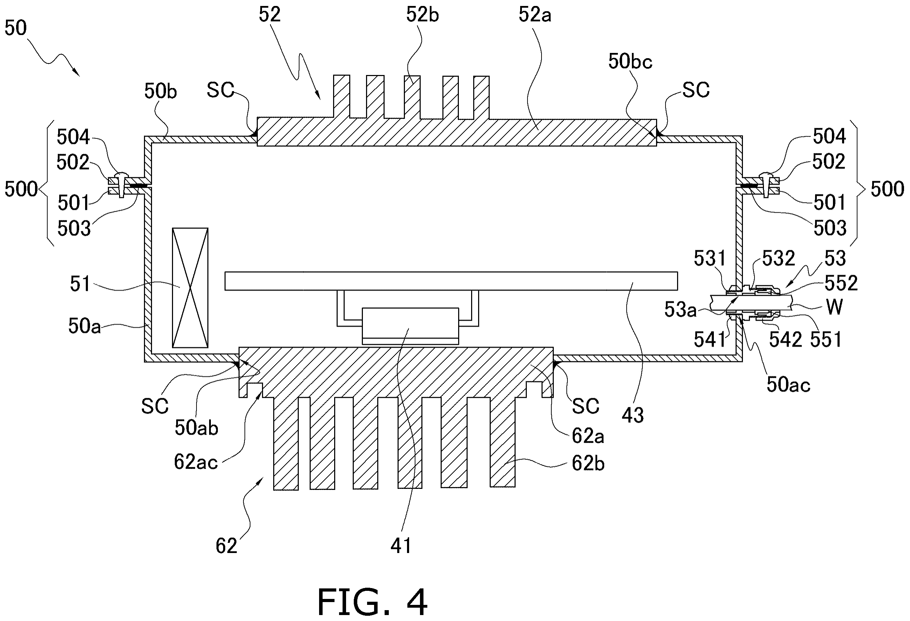

FIG. 4 is an enlarged cross-sectional view of the inner box 50. A printed circuit board 43 on which electric components are mounted, and a first fan 51 that blows air to the printed circuit board 43 are accommodated in the inner box 50. The inner box 50 has a structure in which an inner lid 50b is placed on an inner box body 50a to close an opening of the inner box body 50a.

Both the inner box body 50a and the inner lid 50b are constructed using aluminum or an aluminum alloy. Since the interior of the inner box 50 rises to around 100°C due to the heat dissipation from heat-generating components such as an IPM 41, in order to enhance the heat dissipation of the inner box 50, aluminum or an aluminum alloy is desirable.

### (2-1-1) Inner box body 50a

The inner box body 50a is provided with a square hole 50ab that penetrates the bottom wall. A first heat sink 62 is mounted in the square hole 50ab.

### (2-1-1-1) First heat sink 62

The first heat sink 62 is constructed using aluminum or an aluminum alloy having high thermal conductivity.

The first heat sink 62 includes a rectangular parallelepiped first block 62a and a plurality of first fins 62b protruding from the first block 62a. The first block 62a is attached to cover the square hole 50ab. The gap between the first block 62a and the square hole 50ab is sealed with a sealing material SC.

### (2-1-1-2) Cable gland 53

Furthermore, the inner box body 50a is provided with a round hole 50ac that penetrates the lower part of the side wall. In the round hole 50ac, an electric wire W is guided from the round hole 50ac into the inner box body 50a while being inserted through a cable gland 53.

The cable gland 53 includes a first bolt part 531, a second bolt part 532, a first nut part 541, a second nut part 542, a sealing member 551, and a wedge part 552.

The first bolt part 531 and the second bolt part 532 are integrally formed coaxially. A guide hole 53a through which the electric wire W passes penetrates the first bolt part 531 and the second bolt part 532 in the axial direction.

The first bolt part 531 has a thread outer diameter that is slightly smaller than the round hole 50ac and is inserted into the round hole 50ac. The first nut part 541 is screwed onto the first bolt part 531 inserted into the round hole 50ac. The first bolt part 531 and the first nut part 541 fasten the side wall of the inner box body 50a.

The annular sealing member 551 and the wedge part 552 that annularly covers an outer circumferential surface of the sealing member 551 are inserted into the second bolt part 532. The inner diameter of the annular sealing member 551 is the same as the diameter of the electric wire W, and is in close contact with the electric wire W.

When the second nut part 542 is screwed onto the second bolt part 532, the wedge part 552 is radially compressed to bring the sealing member 551 into close contact with the electric wire W. As a result, the gap between the electric wire W and the inner box 50 is sealed.

### (2-1-2) Inner lid 50b

The inner lid 50b is provided with a square hole 50bc that penetrates the top wall. A second heat sink 52 is mounted in the square hole 50bc. The second heat sink 52 is constructed using aluminum or an aluminum alloy having high thermal conductivity.

The second heat sink 52 includes a rectangular parallelepiped second block 52a and a plurality of second fins 52b protruding from the second block 52a. The second block 52a is attached to cover the square hole 50bc. The gap between the second block 52a and the square hole 50bc is sealed with the sealing material SC.

### (2-1-3) Overlapping part 500

The inner box body 50a is provided with a first flange 501 that surrounds the entire periphery of the opening thereof. The inner lid 50b is also provided with a second flange 502 that surrounds the entire periphery of the opening thereof. After the printed circuit board 43 and the first fan 51 are accommodated in the inner box body 50a, the second flange 502 of the inner lid 50b is superimposed on the first flange 501 of the inner box body 50a, forming an overlapping part 500.

A sealing member 503 is disposed between the first flange 501 and the second flange 502. In addition, a pilot hole for threading a tapping screw 504 in advance is provided in the first flange 501 and the second flange 502.

In a state where the sealing member 503 is sandwiched between the first flange 501 and the second flange 502, by further screwing in the tapping screw 504 inserted into the pilot hole, the first flange 501 and the second flange 502 are fastened in a direction to compress the sealing member 503. As a result, the gap between the first flange 501 and the second flange 502 is sealed.

### (2-1-4) Printed circuit board 43

The printed circuit board 43 has a power device mounted on one surface of a double-sided printed board. In the present embodiment, an intelligent power module (hereinafter referred to as IPM 41) is mounted.

The printed circuit board 43 is oriented with the surface where the IPM 41 is mounted facing the first block 62a of the first heat sink 62. The printed circuit board 43 is disposed with the heat dissipation surface of the IPM 41 adjusted in height to be in contact with the first block 62a. A thermal compound or thermal grease is applied between the first block 62a and the heat dissipation surface of the IPM 41.

The first heat sink 62 is configured to exchange heat between the heat dissipation surface of the IPM 41 and outside air. The heat from the heat dissipation surface of the IPM 41 moves through the first block 62a to the plurality of first fins 62b and is transferred into the air. As a result, the cooling of the IPM 41 is promoted.

### (2-1-5) First fan 51

The first fan 51 is a cooling fan that blows air to the printed circuit board 43. In addition to the IPM 41, heat-generating components are mounted on the printed circuit board 43, and components having smaller heat generation than the IPM 41 are cooled by forced convection by the first fan 51.

### (2-2) Outer box

As shown in FIG. 2, the outer box 60 is located above the fan 29 in the fan chamber 89. The outer box 60 has a structure in which an outer lid 60b is placed on an outer box body 60a to close an upper opening of the outer box body 60a.

The outer box body 60a and the outer lid 60b are both molded using synthetic resin such as ABS resin. Since the periphery of the outer box 60 rises to around 60°C due to heat dissipation from the first heat exchanger 15, synthetic resin is adopted in order to enhance thermal insulation properties with respect to the interior of the outer box 60. However, the outer box body 60a and the outer lid 60b may be molded using foam polypropylene with good thermal insulation properties.

### (2-2-1) Outer box body 60a

The outer box body 60a is provided with a square hole 60ab that penetrates the bottom wall. As shown in FIG. 3, the outer box body 60a is a container that covers the inner box 50. The plurality of first fins 62b of the first heat sink 62 that protrude from the inner box 50 penetrate from the square hole 60ab to be exposed in the fan chamber 89.

In addition, a convex portion 60ac is provided at the peripheral edge of the square hole 60ab. In addition, a concave portion 62ac is provided on the bottom surface of the first block 62a of the first heat sink 62. The inner box 50 is incorporated such that the concave portion 62ac fits into the convex portion 60ac.

In addition, in the front view of FIG. 2, the front wall of the outer box 60 is provided with an opening 60ad. The opening 60ad has a size that occupies most of the front surface of the outer box body 60a, allowing outside air to flow easily. Two positioning projections 60ae are provided at positions that advance a predetermined distance inward from the opening 60ad.

By aligning the inner box 50 to follow the projections 60ae and to cause the first fins 62b of the first heat sink 62 protruding from the inner box 50 to penetrate the square hole 60ab, the concave portion 62ac fits into the convex portion 60ac, whereby the inner box 50 is incorporated into the outer box body 60a.

In addition, a fan mounting hole 60af where a second fan 61 is installed is provided on the side wall of the outer box body 60a. In addition, an introduction hole 60ag that introduces the electric wire W into the outer box 60 is provided on the side wall facing the fan mounting hole 60af.

The fan mounting hole 60af is preferably provided on the side wall of the outer box 60 that is farthest from the partition plate 87, or is preferably provided on the front surface of the outer box 60 when the outer box is viewed from the front of the fan chamber 89, the front surface being the farthest from the partition plate 87 in the outer box 60.

This is because, assuming that a flammable refrigerant leaks from the machine chamber 88, if the fan mounting hole 60af is away from the partition plate 87, the refrigerant is unlikely to be drawn in even if the refrigerant leaks from the machine chamber 88. In the fan chamber 89, the air drawn in from the rear is blown out forward from the front blow-out port. Therefore, if the fan mounting hole is provided on the side wall farthest from the partition plate 87, or on the front surface of the outer box 60, the front surface being the farthest from the machine chamber 88 in the outer box 60, the air containing a flammable refrigerant is unlikely to be drawn in. In the first embodiment, the fan mounting hole 60af is provided on the side wall of the outer box 60 that is farthest from the partition plate 87, as shown in FIG. 3.

### (2-2-2) Outer lid 60b

The outer lid 60b is a lid that closes the upper opening of the outer box body 60a. A rib 60bc that protrudes downward to surround the peripheral edge of the upper opening is provided at the end of the outer lid 60b. In addition, two claw portions 60bd are provided on the front of the outer lid 60b in the front view of FIG. 2.

As shown in FIG. 2, the claw portions 60bd are hooked onto the edge of the opening 60ad of the outer box body 60a, fixing the outer lid 60b to the outer box body 60a.

### (2-2-3) Second fan 61

The second fan 61 is a cooling fan that takes in outside air from the opening 60ad and blows air to the second heat sink 52 that protrudes from the upper part of the inner box 50. The second heat sink 52 is configured to exchange heat between the interior of the inner box 50 and the outside air sent from the second fan 61.

Since the interior of the inner box 50, which has a sealed structure, is easy to rise in temperature, by cooling the interior of the inner box 50 with the second heat sink 52, it is possible to suppress the temperature rise inside the inner box 50.

### (3) Sealing performance of inner box 50

As already described, in the inner box 50, the gap between the first block 62a and the square hole 50ab is sealed with the sealing material SC, the gap between the electric wire W and the inner box 50 is sealed with the cable gland 53, and the gap between the second block 52a and the square hole 50bc is sealed with the sealing material SC.

Furthermore, the gap between the first flange 501 and the second flange 502 of the overlapping part 500 is sealed with the sealing member 503.

The above configuration allows the interior of the inner box 50 to be maintained in a highly sealed state with respect to the outside. Specifically, even if the inner box 50 is left in a gas refrigerant of R290, which is a flammable refrigerant, the concentration of the gas refrigerant that enters the inner box 50 is less than or equal to one-fourth of the explosive concentration of R290.

Therefore, in the unlikely event that a flammable refrigerant leaks in the machine chamber 88 and enters the interior of the outer box 60 of the electric component box 70, the interior of the inner box 50 will not reach the explosive concentration of the flammable refrigerant. Therefore, a high level of safety is ensured.

### (4) Characteristics of first embodiment

(4-1)
   In the electric component box 70, since the inner box 50 has a sealed structure and the inflow of gas into the inner box 50 is suppressed, for example, the contact of air containing a pollutant or flammable gas with electrodes of the electric component is also suppressed.
(4-2)
   The electric component box 70 is disposed in the fan chamber 89. Assuming that a flammable refrigerant leaks in the heat pump unit 100, it is possible to suppress contact between the flammable refrigerant and the electric components in the electric component box 70 by disposing the electric component box 70 in the fan chamber 89, in which the gas concentration is more likely to be lowered by rapid diffusion of the refrigerant by the fan 29, rather than in the machine chamber 88, in which the refrigerant is likely to accumulate.
(4-3)
   In the electric component box 70, the outer box 60 includes the opening 60ad for introducing outside air and the fan mounting hole 60af. Since the interior of the inner box 50, which has a sealed structure, is easy to rise in temperature, it is possible to cool the inner box 50 from the outside by introducing outside air from the outer box 60.
(4-4)
   At least one of opening 60ad and the fan mounting hole 60af are provided on the side wall of the outer box 60 that is farthest from the machine chamber 88, or are provided on the front surface of the outer box 60 when the outer box is viewed from the front of the fan chamber 89, the front surface being the farthest from the machine chamber 88 in the outer box 60.

Assuming that a flammable refrigerant leaks from the machine chamber 88, if at least one of the opening 60ad and the fan mounting hole 60af are away from the machine chamber 88, the refrigerant is unlikely to be drawn in even if the refrigerant leaks from the machine chamber 88.

In the fan chamber 89, the air drawn in from the rear is blown out forward from the front blow-out port. Therefore, if at least one of the opening 60ad and the fan mounting hole 60af are provided on the side wall farthest from the machine chamber 88, or on the front surface of the outer box 60, the front surface being the farthest from the machine chamber 88 in the outer box 60, the air containing a flammable refrigerant is unlikely to be drawn in.
(4-5)
   In the electric component box 70, the second heat sink 52 is configured to exchange heat between the interior of the inner box 50 and the outside air sent from the second fan 61. Since the interior of the inner box 50, which has a sealed structure, is easy to rise in temperature, by cooling the interior of the inner box 50 with the second heat sink 52, it is possible to suppress the temperature rise inside the inner box 50.
(4-6)
   In the electric component box 70, the first heat sink 62 is configured to exchange heat between the heat dissipation surface of the IPM 41 and outside air. The heat from the heat dissipation surface of the IPM 41 moves through the first block 62a to the plurality of first fins 62b and is transferred into the air. As a result, the cooling of the IPM 41 is promoted.
(4-7)
   In the electric component box 70, in addition to the IPM 41, heat-generating components are mounted on the printed circuit board 43, and components having smaller heat generation than the IPM 41 are cooled by forced convection by the first fan 51.
(4-8)
   In the electric component box 70, the second fan 61 takes in outside air from the opening 60ad and blows the air onto the second heat sink 52 that protrudes from the top of the inner box 50, and the second heat sink 52 is configured to exchange heat between the interior of the inner box 50 and the outside air sent from the second fan 61, thereby suppressing the temperature rise inside the inner box 50.
(4-9)
   In the electric component box 70, since the interior of the inner box 50, which has a sealed structure, is easy to rise in temperature, by constructing the inner box 50 using aluminum or an aluminum alloy, the heat dissipation of the inner box 50 is enhanced and the temperature rise inside the inner box 50 is suppressed.
(4-10)
   In the electric component box 70, since the outer box 60 is exposed to air whose temperature has increased through heat exchange with the first heat exchanger 15, by forming the outer box 60 from resin with lower thermal conductivity than metal, the thermal insulation properties of the outer box 60 are enhanced, and the temperature rise inside the outer box 60 is suppressed.
(4-11)
   In the electric component box 70, the gap between the first block 62a and the square hole 50ab in the inner box 50 is sealed with the sealing material SC. The gap between the electric wire W and the inner box 50 is sealed with the cable gland 53. The gap between the second block 52a and the square hole 50bc is sealed with the sealing material SC. Furthermore, the gap between the first flange 501 and the second flange 502 of the overlapping part 500 is sealed with the sealing member 503.

Therefore, the inner box 50 has high sealing performance, and the inflow of the flammable refrigerant into the inner box 50 is suppressed, making the risk of ignition due to contact with the electric components extremely low.

### <Second embodiment>

### (1) Configuration of electric component box 70

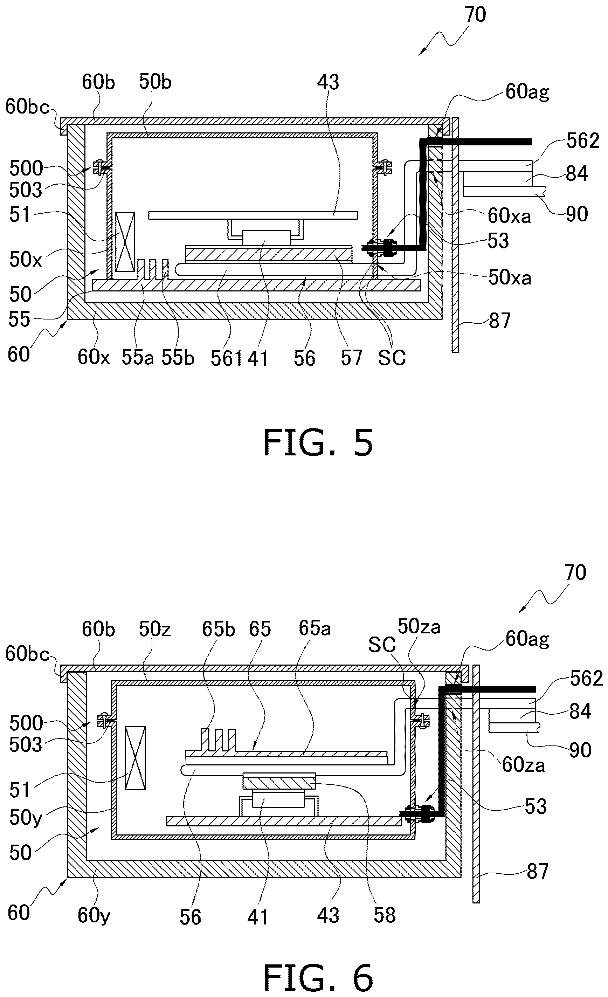

FIG. 5 is a cross-sectional view of an electric component box 70 according to a second embodiment. This differs from the first embodiment in that a heat pipe 56 is introduced inside an inner box 50. With the introduction of the heat pipe 56, an inner box body of the inner box 50 and an outer box body of an outer box 60 have been changed.

Meanwhile, the configuration of an inner lid 50b of the inner box 50, the configuration of a cable gland 53, the configuration of a first fan 51, the configuration of an outer lid 60b of the outer box 60 and an overlapping part 500 have not been changed. Therefore, here, an inner box body 50x of the inner box 50, the heat pipe 56, and an outer box body 60x of the outer box 60, which have been changed from the first embodiment, will be described.

### (1-1) Inner box body 50x

The inner box body 50x includes a third heat sink 55. The third heat sink 55 is constructed using aluminum or an aluminum alloy having high thermal conductivity. The third heat sink 55 includes a third block 55a and a plurality of third fins 55b protruding from the third block 55a.

The third block 55a forms the entire bottom wall of the inner box body 50x. The corner between the third block 55a and the side wall of the inner box body 50x is sealed with a sealing material SC after the third block is joined to the side wall.

As shown in FIG. 5, the first fan 51 blows air from the left side of the third fins 55b, causing heat exchange between the air inside the inner box 50 and the air inside the outer box 60.

In addition, an introduction hole 50xa for introducing the heat pipe 56 into the inner box 50 is provided on the side wall of the inner box body 50x. The gap between the heat pipe 56 and the introduction hole 50xa is sealed with the sealing material SC.

### (1-2) Heat pipe 56

The heat pipe 56 includes an evaporation part 561 located inside the inner box 50 and a condensation part 562 located in a machine chamber 88. A working fluid is sealed inside the heat pipe 56.

The evaporation part 561 is mounted on one surface of a first heat transfer plate 57. In the first heat transfer plate 57, the heat dissipation surface of an IPM 41 is mounted on the opposite surface of the surface where the evaporation part 561 is mounted.

A thermal compound or thermal grease is applied between the evaporation part 561 and the first heat transfer plate 57, and between the first heat transfer plate 57 and the heat dissipation surface of the IPM 41.

The condensation part 562 is mounted on a fourth heat sink 84 disposed in the machine chamber 88. In addition, a refrigerant pipe 90 of a refrigerant circuit is mounted on the fourth heat sink 84. The fourth heat sink 84 is configured to exchange heat between the working fluid inside the condensation part 562 and the refrigerant flowing inside the refrigerant pipe 90.

The working fluid of the heat pipe 56 absorbs heat in the evaporation part 561 and evaporates into a gas. The gasified refrigerant moves to the condensation part 562, where the refrigerant releases heat and returns to a liquid. This operation cools the IPM 41.

As shown in FIG. 5, since the first fan 51 blows air from the left side of the first heat transfer plate 57, the air cooled on the surface of the first heat transfer plate 57 circulates inside the inner box 50.

### (1-3) Outer box body 60x

An introduction hole 60xa for introducing the heat pipe 56 into the outer box 60 is provided on the side wall of the outer box body 60x. The second embodiment does not have a configuration in which the first heat sink 62 of the first embodiment cools the IPM 41 inside the inner box 50. Therefore, the first heat sink 62 that penetrates the inner box 50 and the outer box 60 is not required. Therefore, no through-hole through which a heat sink extends to the outside is required in the outer box body 60x.

### (2) Sealing performance of the inner box 50

As already described, the corner between the third block 55a and the side wall of the inner box body 50x, and the gap between the heat pipe 56 and the introduction hole 50xa are sealed with the sealing material SC. The gap between an electric wire W and the inner box 50 is sealed with the cable gland 53, and the gap of the overlapping part 500 is sealed with the sealing member 503.

The above configuration allows the interior of the inner box 50 to be maintained in a highly sealed state with respect to the outside. Specifically, even if the inner box 50 is left in a gas refrigerant of R290, which is a flammable refrigerant, the concentration of the gas refrigerant that enters the inner box 50 is less than or equal to one-fourth of the explosive concentration of R290.

Therefore, in the unlikely event that a flammable refrigerant leaks in the machine chamber 88 and enters the interior of the outer box 60 of the electric component box 70, the interior of the inner box 50 will not reach the explosive concentration of the flammable refrigerant. Therefore, a high level of safety is ensured.

### (3) Characteristics of second embodiment

The electric component box 70 according to the second embodiment inherits the characteristics of the first embodiment. In addition, since the heat pipe 56 for cooling the interior of the inner box 50 is further provided, the cooling performance is higher than air cooling, and the temperature rise suppression effect inside the inner box 50 is high.

### <Third embodiment>

### (1) Configuration of electric component box 70

FIG. 6 is a cross-sectional view of an electric component box 70 according to a third embodiment. This differs from the first embodiment in that a heat pipe 56 is introduced inside an inner box 50. With the introduction of the heat pipe 56, an inner box body of the inner box 50, an inner lid, an outer box body of an outer box 60, and the posture of a printed circuit board 43 have been changed.

Meanwhile, the configuration of a cable gland 53, the configuration of a first fan 51, the configuration of an outer lid 60b of the outer box 60 and an overlapping part 500 have not been changed.

Therefore, here, an inner box body 50y of the inner box 50, an inner lid 50z, and an outer box body 60y of the outer box 60, which have been changed from the first embodiment, will be described.

### (1-1) Inner box body 50y

The inner box body 50y is a box-shaped container that opens upward. The printed circuit board 43, the heat pipe 56, a second heat transfer plate 58, and a fifth heat sink 65 are disposed in the inner box body 50y. In addition, an electric wire W is introduced through the cable gland 53.

### (1-2) Inner lid 50z

An introduction hole 50za for introducing the heat pipe 56 into the inner box 50 is provided on the side wall of the inner lid 50z. The gap between the heat pipe 56 and the introduction hole 50za is sealed with a sealing material SC.

### (1-3) Printed circuit board 43

The printed circuit board 43 is disposed with the surface on which an IPM 41 is mounted facing upward. The second heat transfer plate 58 is mounted on the heat dissipation surface of the IPM 41. The second heat transfer plate 58 is constructed using aluminum or an aluminum alloy having high thermal conductivity. A thermal compound or thermal grease is applied between the second heat transfer plate 58 and the IPM 41.

### (1-4) Fifth heat sink 65

The fifth heat sink 65 is constructed using aluminum or an aluminum alloy having high thermal conductivity. The fifth heat sink 65 includes a fifth block 65a and a plurality of fifth fins 65b protruding from the fifth block 65a.

### (1-5) Heat pipe 56

The heat pipe 56 includes an evaporation part 561 located inside the inner box 50 and a condensation part 562 located in a machine chamber 88. A working fluid is sealed inside the heat pipe 56.

The evaporation part 561 is sandwiched between one surface of the second heat transfer plate 58 (surface opposite to the mounting surface of the IPM 41) and one surface of the fifth heat sink 65.

The condensation part 562 is mounted on a fourth heat sink 84 disposed in the machine chamber 88. In addition, a refrigerant pipe 90 of a refrigerant circuit is mounted on the fourth heat sink 84. The fourth heat sink 84 is configured to exchange heat between the working fluid inside the condensation part 562 and the refrigerant flowing inside the refrigerant pipe 90.

The working fluid of the heat pipe 56 absorbs heat in the evaporation part 561 and evaporates into a gas. The gasified refrigerant moves to the condensation part 562, where the refrigerant releases heat and returns to a liquid. This operation cools the IPM 41.

As shown in FIG. 6, the first fan 51 blows air from the left side of the fifth heat sink 65, causing heat exchange between the air circulating inside the inner box 50 and the fifth heat sink 65. As a result, the interior of the inner box 50 is cooled.

### (1-6) Outer box body 60x

An introduction hole 60za for introducing the heat pipe 56 into the outer box 60 is provided on the side wall of the outer box body 60x. Since the third embodiment does not have a configuration in which a first heat sink 62 of the first embodiment cools the IPM 41 inside the inner box 50, the first heat sink 62 that penetrates the inner box 50 and the outer box 60 is unnecessary. Therefore, no through-hole through which a heat sink extends to the outside is required in the outer box body 60x.

### (2) Sealing performance of the inner box 50

As already described, the gap between the heat pipe 56 and the introduction hole 50za is sealed with the sealing material SC. The gap between an electric wire W and the inner box 50 is sealed with the cable gland 53, and the gap of the overlapping part 500 is sealed with the sealing member 503.

The above configuration allows the interior of the inner box 50 to be maintained in a highly sealed state with respect to the outside. Specifically, even if the inner box 50 is left in a gas refrigerant of R290, which is a flammable refrigerant, the concentration of the gas refrigerant that enters the inner box 50 is less than or equal to one-fourth of the explosive concentration of R290.

Therefore, in the unlikely event that a flammable refrigerant leaks in the machine chamber 88 and enters the interior of the outer box 60 of the electric component box 70, the interior of the inner box 50 will not reach the explosive concentration of the flammable refrigerant. Therefore, a high level of safety is ensured.

### (3) Characteristics of third embodiment

The electric component box 70 according to the third embodiment inherits the characteristics of the first embodiment. In addition, since the heat pipe 56 for cooling the interior of the inner box 50 is further provided, the cooling performance is higher than air cooling, and the temperature rise suppression effect inside the inner box 50 is high.

The embodiments of the present disclosure have been described above. It will be understood that various modifications to modes and details should be available without departing from the gist and the scope of the present disclosure recited in the claims.

### INDUSTRIAL APPLICABILITY

The sealed structure of the electric component box 70 can be widely utilized in devices in which a flammable refrigerant is used, not limited to the heat pump unit 100.

### REFERENCE SIGNS LIST

41: IPM (intelligent power module)
43: printed circuit board (board)
50: inner box
50a: inner box body (box body)
50ac: (through hole)
50b: inner lid (lid part)
50x: inner box body (box body)
50y: inner box body (box body)
50z: inner lid (lid part)
51: first fan
52: second heat sink
53: cable gland
56: heat pipe
60: outer box
60ad: opening (opening)
60af: fan mounting hole (opening)
61: second fan
62: first heat sink
70: electric component box
87: partition plate
88: machine chamber
89: fan chamber
100: heat source unit
500: overlapping part
501: first flange
502: second flange
503: sealing member

### CITATION LIST

### PATENT LITERATURE

Patent Literature 1: JP A 2008-196767

## Claims

1. An electric component box (70) that is mounted in a heat source unit (100) of a refrigeration apparatus and includes an electric component inside, the electric component box comprising:
an inner box (50) having a sealed structure and accommodating a board (43) on which the electric component is mounted; and
an outer box (60) covering the inner box (50).

2. The electric component box (70) according to claim 1, wherein
an interior of the heat source unit (100) is partitioned by a partition plate (87) into a machine chamber (88) in which a compressor (11) is disposed, and a fan chamber (89) in which a fan (29) and a heat exchanger (15) are disposed, and
the electric component box (70) is disposed in the fan chamber (89).

3. The electric component box (70) according to claim 2, wherein the outer box (60) includes an opening (60ad, 60af) to introduce outside air.

4. The electric component box (70) according to claim 3, wherein the opening (60ad) is provided on a front surface of the outer box (60) when the outer box (60) is viewed from a front surface of the fan chamber (89), the front surface of the outer box (60) being farthest from the machine chamber (88).

5. The electric component box (70) according to any one of claims 1 to 4, wherein a heat sink (52, 62) is attached to the inner box (50).

6. The electric component box (70) according to claim 5, wherein the heat sink (52) is configured to exchange heat between an interior of the inner box (50) and an interior of the outer box (60).

7. The electric component box (70) according to claim 5, wherein the heat sink (62) is configured to exchange heat between an interior of the inner box (50) and an exterior of the outer box (60).

8. The electric component box (70) according to claim 7, wherein
an intelligent power module (41) is mounted on the board (43), and
the heat sink (62) is configured to exchange heat between the intelligent power module (41) and the exterior of the outer box (60).

9. The electric component box (70) according to any one of claims 3 to 8, further comprising a fan (51, 61) that generates air flow.

10. The electric component box (70) according to claim 9, wherein the fan (51) is disposed inside the inner box (50).

11. The electric component box (70) according to claim 9, wherein the fan (61) is disposed in the opening (60ad, 60af) or a space sandwiched between the inner box (50) and the outer box (60).

12. The electric component box (70) according to any one of claims 1 to 11, wherein the inner box (50) is constructed using aluminum or an aluminum alloy.

13. The electric component box (70) according to any one of claims 1 to 12, wherein the outer box (60) is constructed using resin.

14. The electric component box (70) according to any one of claims 1 to 13, further comprising a heat pipe (56) that cools the interior of the inner box (50).

15. The electric component box (70) according to any one of claims 1 to 14, wherein a refrigerant of the refrigeration apparatus includes a flammable refrigerant.

16. The electric component box (70) according to any one of claims 1 to 15, wherein
the inner box (50) includes:
a box body (50a, 50x, 50y) that forms an accommodation space for the board (43); and
a lid part (50b, 50z) that overlaps with the box body (50a) and closes the accommodation space,
an overlapping part (500) between the box body (50a, 50x, 50y) and the lid part (50b, 50z) includes:
a first flange (501) provided on the box body (50a, 50x, 50y);
a second flange (502) provided on the lid part (50b, 50z) to overlap with the first flange (501); and
a sealing member (503) that seals between the first flange (501) and the second flange (502).

17. The electric component box (70) according to claim 16, wherein the overlapping part (500) further includes a fastening member (504) that fastens the first flange (501) and the second flange (502) in a direction to compress the sealing member (503).

18. The electric component box (70) according to claim 16 or 17, wherein
the inner box (50) further includes:
a through hole (50ac) through which a wire (W) passes; and
a cable gland (53) that is inserted into the through hole (50ac) together with the wire (W) and seals between the through hole (50ac) and the wire (W).

19. A heat source unit (100) including the electric component box (70) according to any one of claims 1 to 18.
